# EUROPÄISCHE PATENTANMELDUNG

(11) **EP 1 069 517 A1**
(43) Veröffentlichungstag der Anmeldung: **17.01.2001**
(21) Anmeldenummer: 99810643.9
(22) Anmeldetag: 16.07.1999
(51) Int. Cl.: G06F 17/50

(54) **Visuelle Darstellung von Spannungszuständen auf einem elektrischen Schaltschema**

(71) Anmelder: ABB Power Automation AG, 5401 Baden (CH)
(72) Erfinder: Wimmer, Wolfgang, 5323 Rietheim (CH); Mataji, Babak, 5430 Wettingen (CH)
(74) Vertreter: ABB Patent Attorneys

(57) **Zusammenfassung**

Ein Verfahren, ein Computersystem, ein Computerprogrammsystem und ein Computerprogrammprodukt zur visuellen Darstellung von Spannungszuständen auf einem elektrischen Schaltschema einer Schaltanlage bestimmen Spannungszustände von Leitern anhand von Schalterstellungen und Spannungen der Anlage und färben Linien des Schaltschemas entsprechend den Spannungszuständen ein. Es wird ein Topologiemodell (26) der Anlage verwendet, welches virtuelle Quellen, Schalter und Leitungen als Elementarbausteine, sowie Komponentenregeln zur Bestimmung von Schalterzuständen in Abhängigkeit von Leitungszuständen aufweist. Das Topologiemodell (26) wird aus einem Einzelliniendiagramm, welches Komponenten einer Schaltanlage wie beispielsweise Leitungen, Sammelschienen, Schalter und Transformatoren darstellt, sowie aus generischen (24) und spezifischen Komponentendaten (25) erzeugt.

## Beschreibung

### Technisches Gebiet

Die Erfindung bezieht sich auf das Gebiet der Leittechnik. Sie bezieht sich auf ein Verfahren, ein Computersystem, ein Computerprogrammsystem und ein Computerprogrammprodukt zur visuellen Darstellung von Spannungszuständen auf einem elektrischen Schaltschema einer Schaltanlage gemäss dem Oberbegriff der unabhängigen Patentansprüche.

### Stand der Technik

Schaltanlagen für die Energieverteilung in Hoch- und Mittelspannungsnetzen sind mit Bedienstationen zur Steuerung der Anlagen ausgerüstet. Dazu weisen solche Bedienstationen eine Visualisierung einer Topologie der Anlage auf, welche Komponenten wie elektrische Leitungen, Sammelschienen, Schalter und Transformatoren als elektrisches Schaltschema auf einem Bildschirm darstellt. Dabei werden die Phasen eines elektrischen Dreiphasensystems in einem Einzelliniendiagramm zu einer einzigen Linie zusammengefasst.

Es ist bekannt, in Schemata zur Darstellung elektrischer Verteilnetze die Linien, welche bestimmte elektrische Leitungen darstellen, mit einer Farbe darzustellen, welche einen Spannungszustand dieser Leitung repräsentiert. Eine entsprechende Einfärbung von Leitungen in einem Schaltschema einer Hoch- oder Mittelspannungsschaltanlage ist nicht üblich, weil dies eine aufwendige Modellierung einer Struktur und eines Verhaltens der Schaltanlage bedingt, da die Komplexität einer Schaltanlage wesentlich grösser ist als jene eines Verteilnetzes. Entsprechende Modelle sind anlagenspezifisch und lassen sich nicht wiederverwerten.

### Darstellung der Erfindung

Es ist deshalb Aufgabe der Erfindung, ein Verfahren, ein Computersystem, ein Computerprogrammsystem und ein Computerprogrammprodukt zur visuellen Darstellung von Spannungszuständen auf einem elektrischen Schaltschema der eingangs genannten Art zu schaffen, welche eine einfache Modellierung einer Struktur und eines Verhaltens einer Schaltanlage ermöglichen, wobei sich die Modellierung effizient auf verschiedene Anlagen anwenden lässt.

Diese Aufgabe lösen ein Verfahren, ein Computersystem, ein Computerprogrammsystem und ein Computerprogrammprodukt zur visuellen Darstellung von Spannungszuständen auf einem elektrischen Schaltschema einer Schaltanlage mit den Merkmalen der unabhängigen Patentansprüche.

Im erfindungsgemässen Verfahren zur visuellen Darstellung von Spannungszuständen auf einem elektrischen Schaltschema einer Schaltanlage werden Spannungszustände von Leitern anhand von angenommenen oder gemessenen realen Schalterstellungen und Spannungen einer Anlage bestimmt und Bildelemente des Schaltschemas entsprechend den Spannungszuständen eingefärbt, wobei das Verfahren ein Topologiemodell der Anlage verwendet, welches virtuelle Quellen, Schalter und Leitungen als Elementarbausteine, sowie Komponentenregeln zur Bestimmung von Schalterzuständen in Abhängigkeit von Leitungszuständen aufweist.

In einer bevorzugten Variante der Erfindung wird das Topologiemodell aus einem Einzelliniendiagramm, welches Komponenten einer Schaltanlage wie beispielsweise Leitungen, Sammelschienen, Schalter, Generatoren und Transformatoren darstellt, sowie aus Komponentendaten, das heisst Komponentenstrukturdaten, Komponentenregeln und Komponentenparametern einzelner Komponenten erzeugt.

Die Komponentenstrukturdaten einer Komponente beschreiben vorteilhafterweise einen Aufbau einer generischen Komponente anhand von virtuellen Quellen, Schaltern und Leitungen als Elementarbausteinen. Die Komponentenregeln definieren vorteilhafterweise die Zustände von virtuellen Schaltern in Abhängigkeit von Spannungszuständen von virtuellen Leitungen der Komponente. Die Komponentenparameter beschreiben spezifische Parameter einer realen Komponente.

Die Trennung von Einzelliniendiagramm, Komponentendaten und Topologiemodell erlaubt es, Komponentenstrukturen und Komponentenregeln wiederzuverwenden und dadurch verschiedene Anlagen effizient zu modellieren.

Die Verwendung derselben einfachen Elementarbausteine in allen Komponentenstrukturen erlaubt, ein standardisiertes Analyseverfahren zur Analyse des gesamten Topologiemodells und zur Bestimmung von Linienfarben zu verwenden.

Weitere bevorzugte Ausführungsformen gehen aus den abhängigen Patentansprüchen hervor.

### Kurze Beschreibung der Zeichnungen

Im folgenden wird die Erfindung anhand eines bevorzugten Ausführungsbeispiels, welches in den beiliegenden Zeichnungen dargestellt ist, näher erläutert. Es zeigen:
- Figur 1: ein Einzelliniendiagramm einer Schaltanlage;
- Figur 2: ein Datenflussdiagramm einer Erzeugung eines Topologiemodells; und
- Figur 3: eine Darstellung einer Komponente mittels Elementarbausteinen.

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

### Wege zur Ausführung der Erfindung

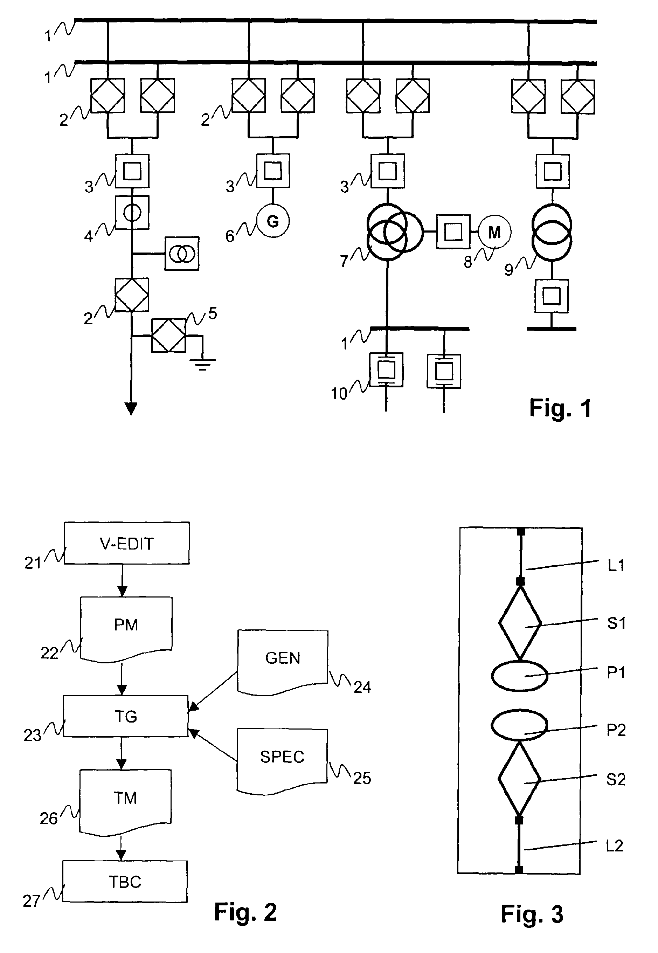

Die Figur 1 zeigt ein Einzelliniendiagramm einer Schaltanlage mit Sammelschienen 1, Abtrennschaltern 2, Schaltern 3, einem Stromwandler 4, Spannungswandler 5, Generator 6, Dreiwindungstransformator 7, Motor 8, Zweiwindungstransformator 9 und Leistungsschaltern mit Wagen (circuit breakers with truck) 10.

Figur 2 zeigt als Überblick über die folgenden Ausführungen ein Datenflussdiagramm: Mittels eines Eingabeprogramms 21 wird ein Anlagenmodell 22 erzeugt. Aus dem Anlagenmodell 22, einer Menge 24 von generischen Komponentenmodellen und spezifischen Komponentendaten 25 wird mittels eines Topologiegenerators 23 ein Topologiemodell 26 erzeugt. Das Topologiemodell 26 wird in einem Analyseverfahren 27 zur Bestimmung von Spannungszuständen analysiert.

Ein Einzelliniendiagramm wird durch einen Benutzer mittels eines Eingabemittels, beispielsweise eines graphischen Eingabeprogramms 21 eines Datenverarbeitungsgerätes oder Rechners in bekannter Weise gezeichnet. Dabei werden einzelne Bildelemente, welche Komponenten der Schaltanlage repräsentierten, innerhalb eines durch ein graphisches Ausgabegerät angezeigten Bildes plaziert und miteinander verbunden. Aufgrund dieser Eingabe werden im Rechner Datenstrukturen, welche die Topologie der Anlage repräsentieren, erzeugt und vorzugsweise in einer Datei abgespeichert. Diese Daten werden Anlagenmodell 22 genannt. Ein Anlagenmodell 22 kann auch aus mehreren Bildern, welche verschiedene Teile der Anlage repräsentieren, gebildet werden. Spezielle Bildelemente repräsentieren Leitungen zu andern Schaltanlagen oder Netzen, mit denen bei einer späteren Bestimmung von Spannungszuständen ein Datenaustausch stattfindet.

Anhand des Anlagenmodells 22 erzeugt ein Mittel zur Verarbeitung des Anlagenmodells oder ein Topologiegenerator 23 ein rechnerbasiertes respektive computerlesbares Topologiemodell 26, welches aus Elementarbausteinen aufgebaut ist. Elementarbausteine sind virtuelle Quellen, Schalter und Leitungen. Das Topologiemodell 26 dient zur Bestimmung von Spannungszuständen der Anlage. Zum besseren Verständnis werden vorerst das Topologiemodell 26 und die Bestimmung von Spannungszuständen erklärt, und anschliessend die Erzeugung des Topologiemodells 26.

Das Topologiemodell 26 ist ein Graph, dessen Zweige Elementarbausteine, also virtuelle Leitungen, Schalter oder Quellen sind. Leitungen und Schalter sind jeweils mit zwei Knoten des Graphs verbunden, Quellen jeweils nur mit einem Knoten. Knoten sind auch mit einer Erdung verbindbar. Schalter befinden sich entweder in einem ersten, geschlossenen oder eingeschalteten Zustand, oder in einem zweiten, geöffneten oder ausgeschalteten Zustand.

Leitungen weisen Spannungszustände auf. Es werden davon vier Hauptzustände unterschieden, je nachdem womit eine Leitung verbunden ist. Verbindungen einer Leitung zu einer Quelle oder Erdung sind gegeben, wenn die Quelle oder Erdung an einem gleichen Knoten wie die Leitung liegt, oder wenn die Quelle oder Erdung über andere Leitungen und über geschlossene Schalter mit der Leitung verbunden ist. Hauptzustände sind:
- Passiv: Die Leitung ist nicht geerdet und nicht mit einer Quelle verbunden.
- Geerdet: Die Leitung ist geerdet und nicht mit einer Quelle verbunden.
- Unbekannt: Beispielsweise ist die Leitung mit einer Quelle verbunden und gleichzeitig geerdet.
- Aktiv: Die Leitung ist mit einer Quelle verbunden. Die Quelle entspricht beispielsweise einem Generator, einer Seite einer Transformators, oder einer Speiseleitung, welche von aussen zur modellierten Schaltanlage führt.

Der Hauptzustand "Aktiv" weist Unterzustände auf, welche unterschiedlich hohen Spannungswerten entsprechen. Vorteilhafterweise wird dabei eine begrenzte Anzahl von diskreten Unterzuständen verwendet. Jedem Haupt- oder Unterzustand ist eine Farbe zugeordnet, welche beim Einfärben des Einzelliniendiagramms verwendet wird. Vorteilhafterweise werden Unterzuständen, die nahe beieinanderliegenen Spannungswerten entsprechen, ähnliche Farben oder die gleiche Farbe zugeordnet.

Zur Analyse 27 einer Schaltanlage anhand des entsprechenden Topologiemodells 26 wird in einem entsprechenden Mittel 27 zur Auswertung des Topologiemodells davon ausgegangen, dass Spannungszustände von einzelnen Quellen sowie die Stellungen von Schaltern, welche realen Schaltern entsprechen, bekannt sind. Dazu weist der Rechner eine Kommunikationsverbindung zu einer realen Schaltanlage auf, mittels welcher gemessene Spannungen und Schalterzustände übermittelt werden. In einer anderen Ausführungsform der Erfindung ist der Rechner nicht mit einer realen Schaltanlage verbunden, sondern es werden Werte für bestimmte Spannungen und Schalterstellungen als vorgegeben angenommen. Ausgehend von diesen gemessenen oder angenommenen Spannungen werden im Topologiemodell 26 entsprechende Quellen als aktiv mit einem entsprechenden Unterzustand gesetzt, und ausgehend von den gemessenen oder angenommenen Schalterstellungen werden Zustände von virtuellen Schaltern des Topologiemodells 26 als geöffnet oder geschlossen gesetzt. Ausgehend von aktiven Quellen werden die Spannungszustände von Leitungen gemäss Propagationsregeln ermittelt. Propagationsregeln sind beispielsweise:
- Wenn eine erste Leitung, deren Spannungszustand noch nicht bestimmt worden ist, eine Quelle oder eine zweite Leitung mit bekanntem Spannungszustand trifft, das heisst, dass die erste Leitung über einen gemeinsamen Knoten oder einen geschlossenen Schalter mit der Quelle respektive der zweiten Leitung verbunden ist, so erhält die erste Leitung den Zustand der Quelle respektive der zweiten Leitung.
- Wenn eine geerdete Leitung auf eine aktive Leitung trifft, wird der Zustand für beide Leitungen als unbekannt gesetzt.
- Wenn zwei aktive Leitungen aufeinandertreffen, erhalten beide als Unterzustand den höheren Spannungswert der beiden Leitungen.

Weitere Kombinationen von Zuständen werden durch entsprechende weitere Propagationsregeln behandelt. Die Gesamtheit dieser Regeln sowie ein Verfahren zur Abarbeitung der Regeln bilden das Analyseverfahren 27 zur Bestimmung von Spannungszuständen.

Um das Topologiemodell 26 erzeugen zu können, benötigt der Topologiegenerator 23 Informationen über einen inneren Aufbau und eine Funktionsweise der Komponenten. Diese Informationen sind einerseits generischer, andererseits spezifischer Art.

Generische Informationen beschreiben einen Typ oder eine Klasse von Geräten, beispielsweise Schalter oder Transformatoren. Generische Informationen über eine Komponente werden auch als Komponentenmodell bezeichnet. Sie beinhalten eine Komponentenstruktur, das heisst, eine Repräsentation der Komponente durch Elementarbausteine, sowie Komponentenregeln, das heisst Regeln über das Verhalten einzelner Elementarbausteine der Komponente in Abhängigkeit von Spannungszuständen anderer Elementarbausteine der Komponente. Komponentenmodelle werden nur einmal erzeugt, beispielsweise bei der Erstellung oder Verbesserung von Softwarewerkzeugen zur Realisierung der Erfindung. Aus mehreren Komponentenmodellen wird ein Satz 24 von Komponentenmodellen gebildet und in der Darstellung und Analyse beliebiger Schaltanlagen wiederverwendet.

Figur 3 zeigt die Komponentenstruktur eines Transformators mit zwei Wicklungssätzen. Auf einer ersten Seite des Transformators ist eine erste virtuelle Leitung L1 über einen ersten virtuellen Schalter S1 mit einer ersten virtuellen Quelle P1 verbunden, und auf einer zweiten Seite des Transformators ist eine zweite virtuelle Leitung L2 über einen zweiten virtuellen Schalter S2 mit einer zweiten virtuellen Quelle P2 verbunden. Dazugehörige Komponentenregeln des Transformators besagen, dass der Schalter S2 geschlossen ist, falls die Leitung L1 aktiv ist, und dass der Schalter S1 geschlossen ist, falls die Leitung L2 aktiv ist.

Die Schalter S1 und S2 entsprechen keinen realen Schaltern, sondern bilden zusammen mit den Komponentenregeln des Transformators eine Repräsentation des Verhaltens des Transformators welches durch das oben beschriebene Analyseverfahren 27 verarbeitet werden kann.

Spezifische Informationen beschreiben einzelne, konkrete Geräte eines Typs, beispielsweise einen Transformator mit bestimmten Wicklungsverhältnissen und Nennspannungen. Im Zusammenhang mit dem Topologiemodell beschreiben spezifische Informationen Komponentenparameter wie Name und Nummer einer Komponente, sowie, welche Unterzustände ein Anschluss der Komponente in Abhängigkeit eines internen Zustands aufweisen kann. Beispielsweise wird ein Transformator durch die folgenden Parameter charakterisiert:
1. Stationsname
2. Unterstationsname
3. Gerätename
4. Geräteidentifikation
5. Unterzustand von Quelle 1
6. Unterzustand von Quelle 2

Die Unterzustände der Quellen werden auf den zugeordneten Leitungen wirksam, wenn die entsprechenden Schalter geschlossen sind. Die Gesamtheit aller Komponentendaten der Komponenten einer Anlage ist mit dem Bezugszeichen 25 bezeichnet.

Der Topologiegenerator 23 verknüpft die Komponentenstrukturen der einzelnen Komponenten eines gegebenen Einzelliniendiagramms zu einem Topologiemodell. Die Komponentenregeln und -daten 25 werden entsprechenden Elementarbausteinen des Topologiemodells 26 zugeordnet, so dass sie durch das Analyseverfahren 27 verarbeitbar sind. Das Analyseverfahren 27 bestimmt wie oben beschrieben zugeordnete Spannungszustände von Quellen, Schaltern und Leitungen, indem
1. von angenommenen oder gemessenen realen Schalterstellungen und Spannungen ausgegangen wird,
2. daraus für mindestens eine erste Quelle oder eine erste Leitung ein Spannungzustand bestimmt wird,
3. und unter Verwendung von Propagationsregeln und Komponentenregeln Spannungszustände von übrigen, zweiten Leitungen und von übrigen, zweiten Quellen bestimmt werden.

Anschliessend setzt das Verfahren in einem Einzelliniendiagramm die Farben von Bildelementen nach Massgabe der Spannungszustände der Elementarbausteine der Komponenten, welche durch diese Bildelemente repräsentiert werden. Vorzugsweise werden dabei die Farben von Sammelschienen und anderen Leitungen des Einzelliniendiagramms gesetzt, aber auch Farben von Transformatoren, Generatoren und anderen Bildelementen, welche Anlagenkomponenten repräsentieren. Vorzugsweise ist das hier verwendete Einzelliniendiagramm dasselbe, welches mittels des Eingabeprogramms 21 erzeugt wurde.

In einer bevorzugten Variante der Erfindung erlauben Mittel zur Bestimmung einer visuellen Darstellung des Schaltschemas, Bildinhalte dieses Schaltschemas zu berechnen, und erlauben Mittel zur visuellen Darstellung des Schaltschemas, dieses Schaltschema an einem Bildschirm anzuzeigen und/oder mittels eines Druckers auszudrucken.

In einer weiteren Variante der Erfindung werden anstelle von unterschiedlichen Farben unterschiedliche Muster und/oder Helligkeiten zur Anzeige von Spannungszuständen verwendet.

Die Programmelemente zur Umsetzung des erfindungsgemässen Analyseverfahrens und der visuellen Darstellung der Analyseresultate bilden zusammen ein erfindungsgemässes Computerprogrammprodukt. Dieses Computerprogrammprodukt bildet zusammen mit dem Topologiegenerator ein erfindungsgemässes Computerprogrammsystem, welches auf einem erfindungsgemässen Computersystem ausgeführbar ist. Dabei sind das Computerprogrammprodukt und das Computerprogrammsystem in bekannter Weise auf computerlesbaren Medien wie Disketten, CD-ROMs, Magnetbändern etc. speicherbar.

### Bezugszeichenliste

- 1: Sammelschiene
- 2: Abtrennschalter
- 3: Schalter
- 4: Stromwandler
- 5: Spannungswandler
- 6: Generator
- 7: Dreiwindungstransformator
- 8: Motor
- 9: Zweiwindungstransformator
- 10: Leistungsschalter mit Wagen (circuit breakers with truck)
- 21: 21 Eingabeprogramm V-EDIT
- 22: Anlagenmodell PM
- 23: Topologiegenerator TG
- 24: Menge von generischen Komponentenmodellen GEN
- 25: spezifische Komponentendaten SPEC
- 26: Topologiemodell TM
- 27: Analyseverfahren TBC
- L1: erste virtuelle Leitung
- L2: zweite virtuelle Leitung
- S1: erster virtueller Schalter
- S2: zweiter virtueller Schalter
- P1: erste virtuelle Quelle
- P2: zweite virtuelle Quelle

## Patentansprüche

1. Verfahren zur visuellen Darstellung von Spannungszuständen auf einem elektrischen Schaltschema, welches Komponenten einer Schaltanlage darstellt, wobei Linien, welche elektrische Leiter darstellen, nach Massgabe von Schalterstellungen und Spannungen der Schaltanlage mit unterschiedlichen Farben dargestellt werden, dadurch gekennzeichnet,
dass dabei ein Topologiemodell (26), welches virtuelle Quellen, Schalter und Leitungen beinhaltet, verwendet wird, wobei eine Komponente jeweils durch eine bestimmte generische Kombination von virtuellen Quellen, Schaltern und Leitungen, durch spezifische Komponentenparameter sowie durch generische Komponentenregeln repräsentiert wird,
dass jeder virtuellen Quelle und Leitung jeweils ein eigener Spannungszustand zugeordnet wird, indem von angenommenen oder gemessenen realen Schalterstellungen und Spannungen ausgegangen wird, daraus für mindestens eine erste Quelle oder eine erste Leitung ein Spannungzustand bestimmt wird, und unter Verwendung von Propagationsregeln und Komponentenregeln Spannungszustände von übrigen, zweiten Leitungen und von übrigen, zweiten Quellen bestimmt werden,
und dass die Farben der visuellen Darstellung aufgrund der Spannungszustände der virtuellen Leitungen und Quellen bestimmt werden.

2. Verfahren gemäss Anspruch 1, dadurch gekennzeichnet, dass das Topologiemodell (26) aus einem Komponenten darstellenden Einzelliniendiagramm der Schaltanlage sowie aus Komponentenstrukturdaten, Komponentenparametern und Komponentenregeln erzeugt wird.

3. Computersystem zur visuellen Darstellung von Spannungszuständen auf einem elektrischen Schaltschema, welches Komponenten einer Schaltanlage darstellt, wobei Linien, welche elektrische Leiter darstellen, nach Massgabe von Schalterstellungen und Spannungen der Schaltanlage mit unterschiedlichen Farben dargestellt sind, dadurch gekennzeichnet,
dass das Computersystem ein Topologiemodell (26), welches virtuelle Quellen, Schalter und Leitungen aufweist, wobei eine Komponente jeweils durch eine bestimmte generische Kombination von virtuellen Quellen, Schaltern und Leitungen, durch spezifische Komponentenparameter sowie durch generische Komponentenregeln repräsentiert ist,
Mittel (27) zur Auswertung dieses Topologiemodells (26) und zur Bestimmung von Spannungszuständen von Leitern nach Massgabe von angenommenen oder gemessenen realen Schalterstellungen und Spannungen der Schaltanlage,
sowie Mittel zur visuellen Darstellung von Leitern der Anlage, wobei Linien zur Darstellung von Leitern mit unterschiedlichen Farben, welche Spannungszuständen entsprechen, dargestellt sind, aufweist.

4. Computersystem gemäss Anspruch 3, dadurch gekennzeichnet, dass es Mittel zur Eingabe eines Einzelliniendiagramms der Schaltanlage und zur Erzeugung einer computerlesbaren Darstellung dieses Diagramms, sowie Mittel (23) zur Verarbeitung dieser Darstellung, von Komponentenstrukturdaten, Komponentenparametern und Komponentenregeln und zur Erzeugung eines Topologiemodells (26) aufweist.

5. Computerprogrammsystem zur visuellen Darstellung von Spannungszuständen auf einem elektrischen Schaltschema, welches Komponenten einer Schaltanlage darstellt, wobei Linien, welche elektrische Leiter darstellen, nach Massgabe von Schalterstellungen und Spannungen der Schaltanlage mit unterschiedlichen Farben dargestellt sind, dadurch gekennzeichnet,
dass das Computerprogrammsystem ein Topologiemodell (26), welches virtuelle Quellen, Schalter und Leitungen aufweist, wobei eine Komponente jeweils durch eine bestimmte generische Kombination von virtuellen Quellen, Schaltern und Leitungen, durch spezifische Komponentenparameter sowie durch generische Komponentenregeln repräsentiert ist, Mittel (27) zur Auswertung dieses Topologiemodells (26) und zur Bestimmung von Spannungszuständen von Leitern nach Massgabe von angenommenen oder gemessenen realen Schalterstellungen und Spannungen der Schaltanlage,
sowie Mittel zur Bestimmung einer visuellen Darstellung von Leitern der Anlage, wobei Linien zur Darstellung von Leitern mit unterschiedlichen Farben, welche Spannungszuständen entsprechen, dargestellt sind, aufweist.

6. Computerprogrammsystem gemäss Anspruch 5, dadurch gekennzeichnet, dass es Mittel zur Eingabe eines Einzelliniendiagramms der Schaltanlage und zur Erzeugung einer computerlesbaren Darstellung dieses Diagramms,
sowie Mittel (23) zur Verarbeitung dieser Darstellung, von Komponentenstrukturdaten, Komponentenparametern und Komponentenregeln und zur Erzeugung eines Topologiemodells (26) aufweist.

7. Computerprogrammprodukt zur visuellen Darstellung von Spannungszuständen auf einem elektrischen Schaltschema, welches Komponenten einer Schaltanlage darstellt, wobei Linien, welche elektrische Leiter darstellen, nach Massgabe von Schalterstellungen und Spannungen der Schaltanlage mit unterschiedlichen Farben dargestellt sind, dadurch gekennzeichnet,
dass das Computerprogrammprodukt ein Topologiemodell (26), welches virtuelle Quellen, Schalter und Leitungen aufweist, wobei eine Komponente jeweils durch eine bestimmte generische Kombination von virtuellen Quellen, Schaltern und Leitungen, durch spezifische Komponentenparameter sowie durch generische Komponentenregeln repräsentiert ist, Mittel (27) zur Auswertung dieses Topologiemodells (26) und zur Bestimmung von Spannungszuständen von Leitern nach Massgabe von angenommenen oder gemessenen realen Schalterstellungen und Spannungen der Schaltanlage,
sowie Mittel zur Bestimmung einer visuellen Darstellung von Leitern der Anlage, wobei Linien zur Darstellung von Leitern mit unterschiedlichen Farben, welche Spannungszuständen entsprechen, dargestellt sind, aufweist.
